# EUROPEAN PATENT APPLICATION

(11) **EP 4 343 432 A1**
(43) Date of publication of application: **27.03.2024**
(21) Application number: 22197213.6
(22) Date of filing: 22.09.2022
(51) Int. Cl.: G03F 7/004

(54) **USE OF A METAL AND/OR METALLOID-COMPRISING KETOACIDOXIMATE AND/OR A METAL-COMPOUND-COMPRISING KETOACIDOXIMATE AS A PATTERNING AGENT**

(71) Applicant: PAUL SCHERRER INSTITUT, 5232 Villigen PSI (CH)
(72) Inventor: Saifullah, Mohammad, Cambridge, CB1 9JY (GB)
(74) Representative: Fischer, Michael

(57) **Abstract**

The present invention relates to the use of a metal or metal-compound comprising ketoacidoximate as a patterning agent, preferably a photoresist agent, in photolithography and/or electron beam patterning. Preferably, the metal or metal-compound comprising ketoacidoximate has one of the following structural forms: 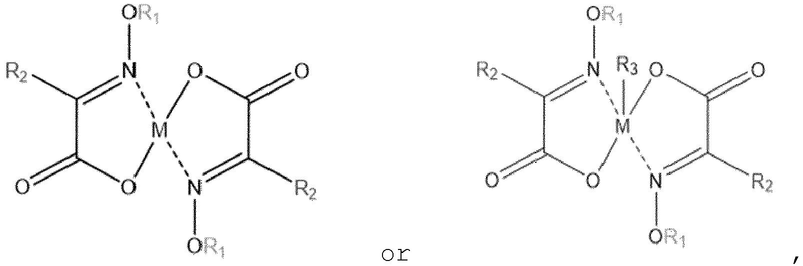 wherein:
R₁ and R₂ stand for hydrogen (H), organic compounds, such as aliphatic C₁ to C₁₀, aromatic, cyclic, polymerizable, such as acrylate, methacrylate, vinyl, etc., or a combination of these; and
M stands for a central metal or metalloid atom that is attached to the ketoacidoximate group, and/or for a central metal atom being attached to other groups such as oxide, hydroxide, etc., or a central metal atom being attached to a further group R₃ which is a carboxylate such as acetate, etc., a glycinate, a xanthate, an alkyl, an aryl, or the like.

## Description

The present invention relates to the use of specific chemical compounds as patterning agents in the photolithography and/or electron beam patterning. It can be used in the field of semiconductor chip production, particularly but not limited to EUV wavelengths, and direct patterning of functional materials for applications such as masks in semiconductor industry, sensors, photonics or catalysis.

Photolithography has been the bedrock of fabricating devices in micro- and nanometer regime in the semiconductor industry. It uses a resist, usually a photosensitive polymeric material, for imaging and pattern transfer to a substrate either via the process of plasma etching or by lift-off after metal (oxide) deposition. The pursuit of ever-shrinking critical dimensions from micrometers to a few tens of nanometers presently has been made possible by adopting increasingly shorter wavelength imaging radiation (193 nm since early 2000s) coupled with some technological ingenuity in the last decade such as immersion lithography and multiple exposure patterning. Achievement of higher resolution from a simpler direct photo-exposure comes at a large increase in capital cost as it needs shorter wavelength imaging radiation and a suitable resist to take its advantage.

In recent years, EUV technology (13.5 nm wavelength) has emerged as the strong alternative to ArF immersion lithography for high volume manufacturing. To take the advantage of the EUV light source, which suffers from limited power, requires development of novel resist materials that possess high sensitivity at this wavelength, capable of high resolution, exhibit low line edge roughness (LER), and at the same time preserving the pattern fidelity and uniformity. Chemically amplified resists (CAR), which are primarily organic, have served very well in 248 nm and 193 nm lithography but are very transparent in EUV wavelength.

This represents a major problem as it leads to the reduction of sensitivity of these resists. On other hand, incorporation of certain metals in thin resists lead to high EUV absorbance resulting in improved sensitivity, mitigation of photon-shot-noise effects, and at the same time serve as a durable etch mask.

For these reasons, new resists containing atoms that show increased absorbance at the EUV wavelength have been put forth as a substitute for CARs.

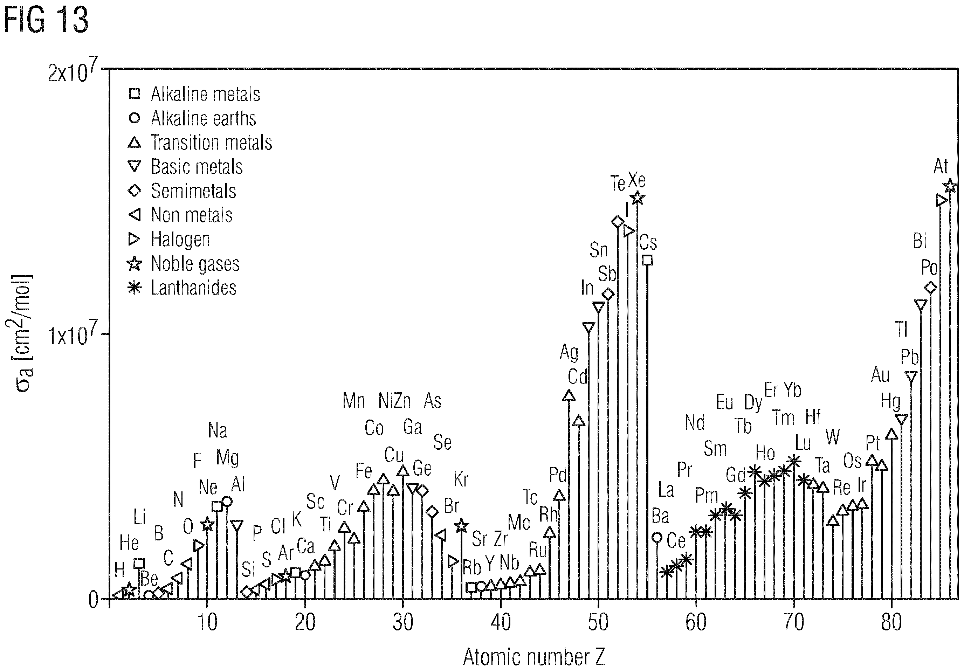

The graph in Figure 13 provides theoretically calculated EUV absorption cross-section of various elements. The data here provide guidelines for the choice of elements in EUV resists that would increase the absorption of radiation. Typically, elements with higher EUV absorption cross-section are preferred.

It is therefore the objective of the present invention to provide a patterning agent, such as a photo-resist, that has high EUV absorbance resulting in improved sensitivity, high patterning resolution and low line edge roughness, and at the same time serve as a durable etch mask in semiconductor chip production. It would desirable when the same patterning agent could also serve as an electron beam-sensitive resist in electron beam lithography for direct patterning of functional materials, such as high-refractive index nanopatterns for photonic applications or high-absorbance materials for EUV photomasks.

This objective is achieved according to the present invention by the use of a metal and/or metalloid-comprising ketoacidoximate and/or a metal-compound-comprising ketoacidoximate as a patterning agent in photolithography and electron beam lithography with applications in the field of semiconductor chip production, and direct patterning of functional materials for mask production, sensors, photonics or catalysis.

Surprisingly, metal and/or metalloid-comprising ketoacidoximate and/or a metal-compound-comprising ketoacidoximate show exactly the desired properties in terms of high EUV absorbance or electron beam sensitivity that results in the desired sensitivity.

Typically, a divalent metal or metalloid or metal-compound comprising ketoacidoximate can have one of the following structural forms: 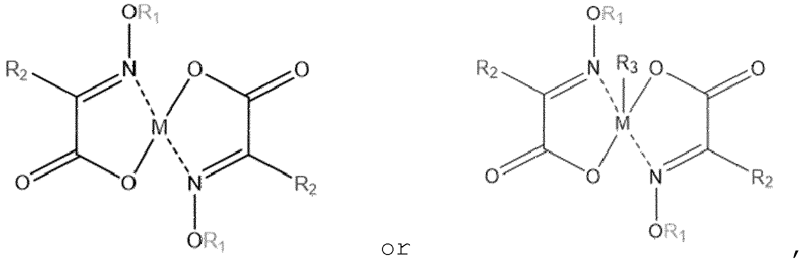 wherein:
R₁ and R₂ stand for hydrogen (H), organic groups, such as aliphatic C₁ to C₁₀, aromatic, cyclic, polymerizable, such as acrylate, methacrylate, vinyl, etc., or a combination of these; and
M stands for a central metal or metalloid atom, which can be monovalent, divalent, trivalent, tetravalent, pentavalent or higher, that is attached to the ketoacidoximate group in monodentate, bidentate, or tridentate fashion, and/or for a central metal atom being attached to other groups such as oxide, hydroxide, etc., or M stands for a central metal atom being attached to a further group R₃ which is a carboxylate such as acetate, etc., a glycinate, a xanthate, an alkyl, an aryl, or the like.

Preferably, the metal atom selected from a group comprising zinc, indium, aluminium, nickel, magnesium, and tin.

Preferred embodiments of the present invention are described hereinafter in more detail with reference to the attached drawings which depict in:
- Figure 1: Dose-to-gel curves of zinc(II) methoxyimino propionate resist exposed to (a) EUV and (b) electron beam; (c) Sensitivity values of the resist obtained with various developers;
- Figure 2: EUV lithography of (a) half pitch 22 nm (325 mJ/cm²), (b) half-pitch 18 nm (297 mJ/cm²), and (c) half pitch 16 nm (290 mJ/cm²) lines using zinc(II) methoxyimino propionate resist;
- Figure 3: Electron beam lithography of 5 nm wide lines patterned using zinc(II) methoxyimino propionate resist;
- Figure 4: Dose-to-gel curves of indium(III) hydroxyimino propionate resist exposed to (a) EUV and (b) electron beam; (c) Sensitivity values of the resist obtained with various developers;
- Figure 5: EUV lithography of (a) half pitch 22 nm (222 mJ/cm²), (b) half-pitch 18 nm (223 mJ/cm²), and (c) half pitch 16 nm (199 mJ/cm²) lines using indium(III) hydroxyimino propionate resist;
- Figure 6: Dose-to-gel curves of indium(III) methoxyimino propionate resist exposed to (a) EUV and (b) electron beam; (c) Sensitivity values of the resist obtained with various developers;
- Figure 7: EUV lithography of (a) half pitch 22 nm (193 mJ/cm²), (b) half-pitch 18 nm (194 mJ/cm²), and (c) half pitch 16 nm (173 mJ/cm²) lines using indium(III) methoxyimino propionate resist;
- Figure 8: Dose-to-gel curves of aluminium(III) methoxyimino propionate resist exposed to (a) EUV and (b) electron beam; (c) Sensitivity values of the resist obtained with various developers;
- Figure 9: EUV lithography of (a) half pitch 50 nm (64 mJ/cm²), and (b) half-pitch 35 nm (51 mJ/cm²) using aluminium(III) methoxyimino propionate resist;
- Figure 10: Dose-to-gel curves of nickel(II) methoxyimino propionate resist exposed to (a) EUV and (b) electron beam; (c) Sensitivity values of the resist obtained with various developers;
- Figure 11: Dose-to-gel curves of magnesium(II) methoxyimino propionate resist exposed to (a) EUV and (b) electron beam; (c) Sensitivity values of the resist obtained with various developers;
- Figure 12: Dose-to-gel curves of tin(II) methoxyimino propionate resist exposed to (a) EUV and (b) electron beam; (c) Sensitivity values of the resist obtained with various developers; and
- Figure 13: Atomic absorption cross section σₐ at EUV (λ = 13.5 nm) of elements with atomic number Z from 1 to 86.

In the following, a number of methods for making metal- and metalloid-containing compounds for lithographic patterning of substrates, such as Extreme Ultraviolet (EUV) and Electron Beam Lithographies, are explained in more detail. In general, the compound family of the ketoacidoximates can be used in these applications in terms of a photoresist, an electron beam resist, a precursor for metal or metal oxide patterning.

Since metal/metalloid ketoacidoximates are known in the art, one would have expected them to be commercially available, but they aren't so far. Thus, they have to be synthesized in the laboratory. The first step involves condensation of an α-keto acid with an amine to give α-oximino acid.

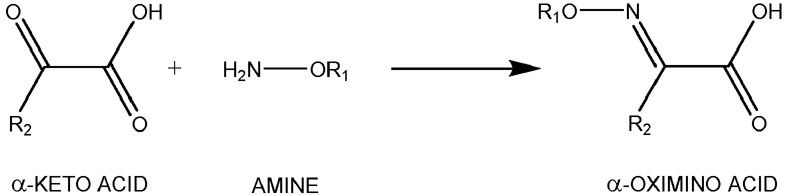

The α-oximino acid is then reacted with a metal/metalloid salt (e.g., nitrate or chloride) in the presence of a suitable base to given metal/metalloid ketoacidoximate as shown below. The reaction can be carried out in either organic or an aqueous medium.

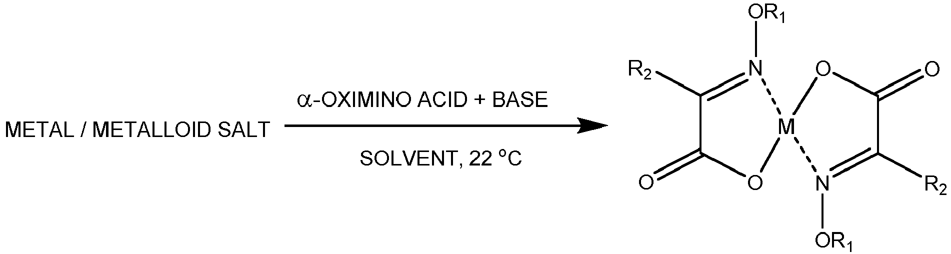

Synthesized metal/metalloid ketoacidoximates are found to be sensitive to energetic electrons (0.5 to 300 kV), extreme ultraviolet (EUV) radiation (92 eV, 13.5 nm) and other types of energetic radiation below 250 nm wavelength. Such sensitivity to electrons and EUV radiation (among others) have made them patternable and henceforth they will be called "metal(loid)-containing patterning agents" or simply "patterning agents".

Since the condensation involves α-keto acid and an amine to give α-oximino acid, the organic groups attached to amine (R₁) and α-keto acid (R₂) can be individually and independently modified. These groups can be hydrogen (H), aliphatic (C₁-C₁₀), aromatic, cyclic, polymerizable (acrylate, methacrylate, vinyl, etc.), or a combination of these. First, we provide representative examples of modification of organic groups attached to amine (R₁, light grey) are presented which keeping group in R₂ (dark grey) as H.

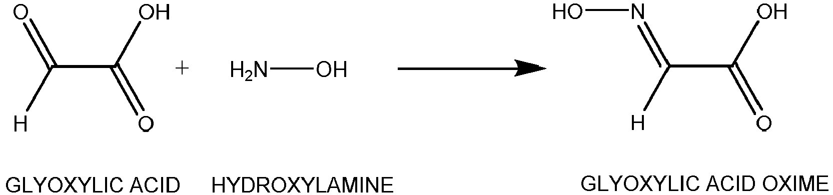

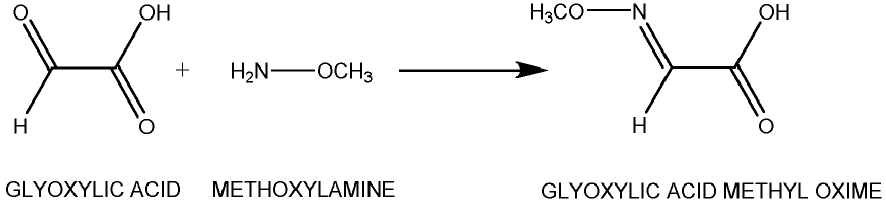

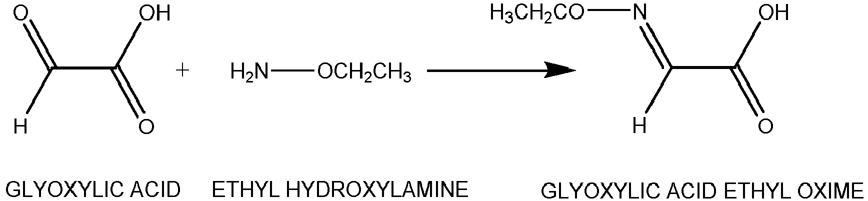

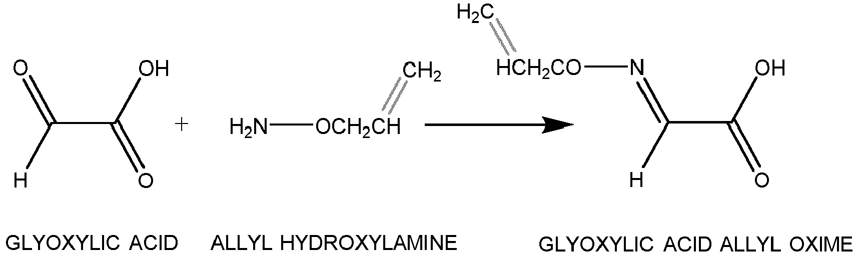

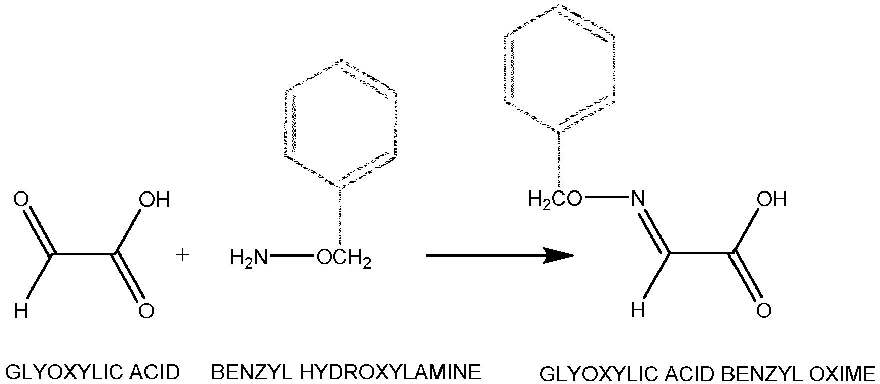

Next, some representative examples of modification organic groups attached to α-keto acid (R₂) are provided which keeping group in fixed.

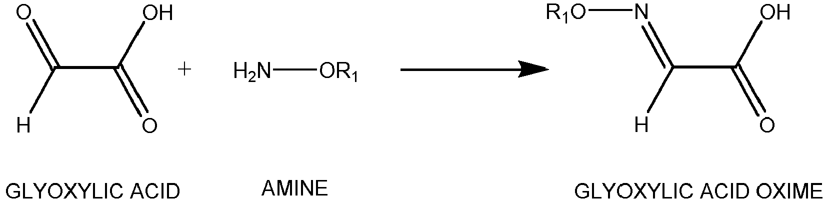

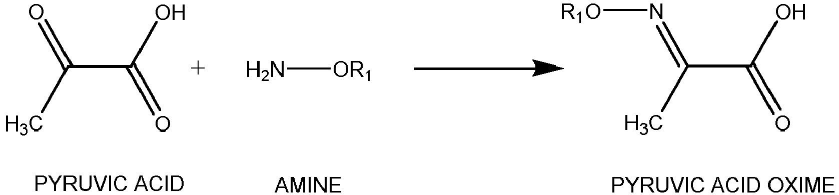

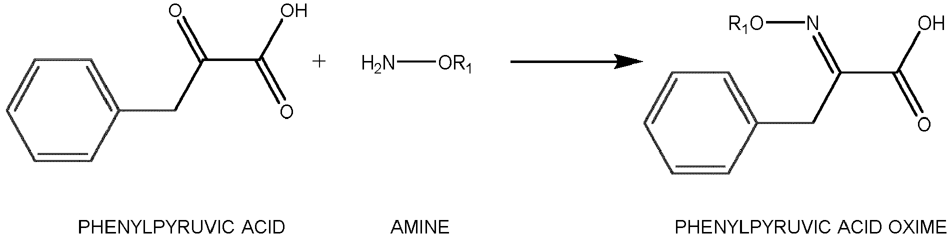

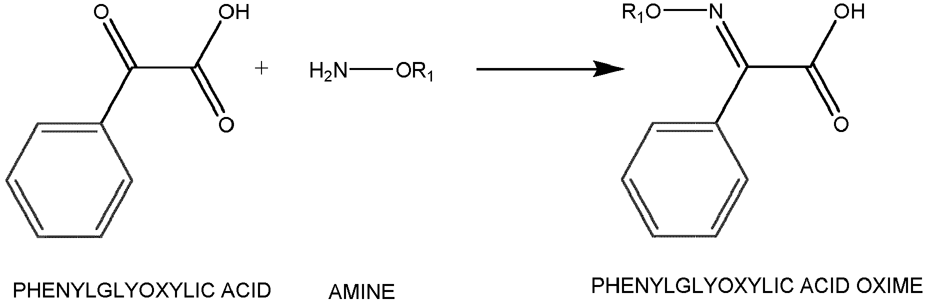

Further flexibility can also be obtained by adding a halogen group to α-ketoacid. Representative examples of pyruvic acid are given below.

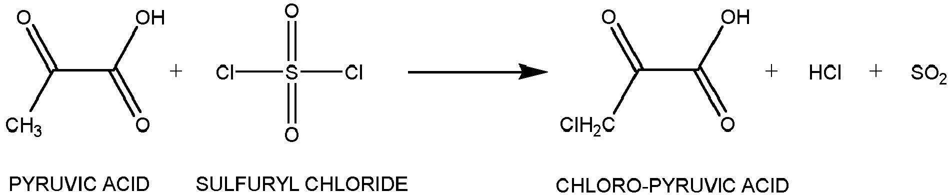

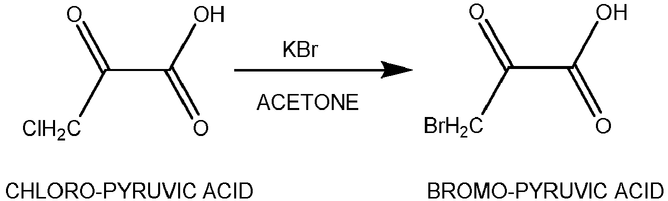

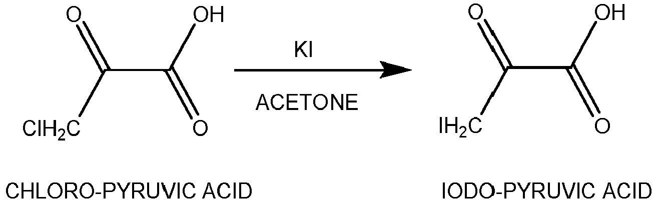

From the above representative examples, one can see that there are at least 20 possible ways in which the organic environment around a central metal atom can be modified. Such a versatility in synthesis of an α-oximino acid and finally its metal or metalloid salt from it provides tailorability of the patterning agents's sensitivity (for example in terms of a photoresist) to energetic electrons and photons, solubility in organic solvents, and film formability on a silicon substrate. At least 40 patterning agents resists of different metals and metalloids were synthesized using the above-mentioned procedure, out of which 30% were spin-coatable and patternable using electrons and photons. Following are the representative examples of the resists that were prepared by synthetic procedure described above which were found to be patternable.

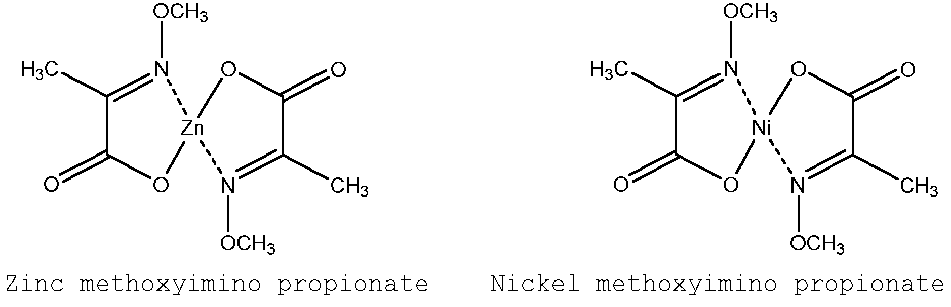

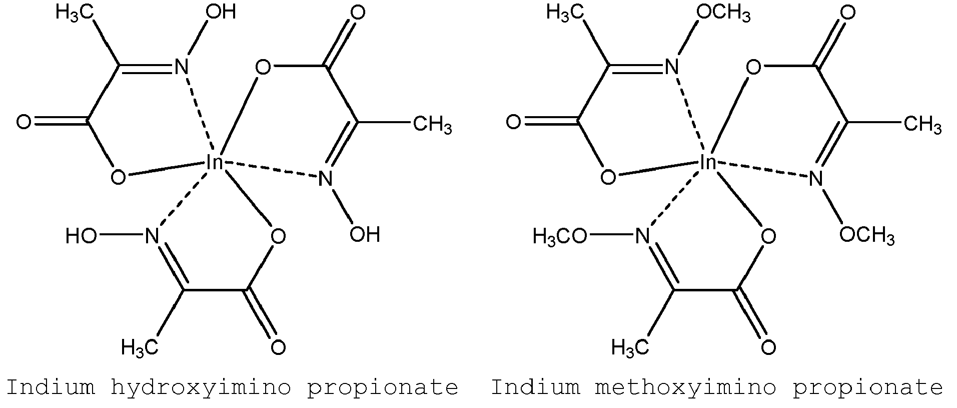

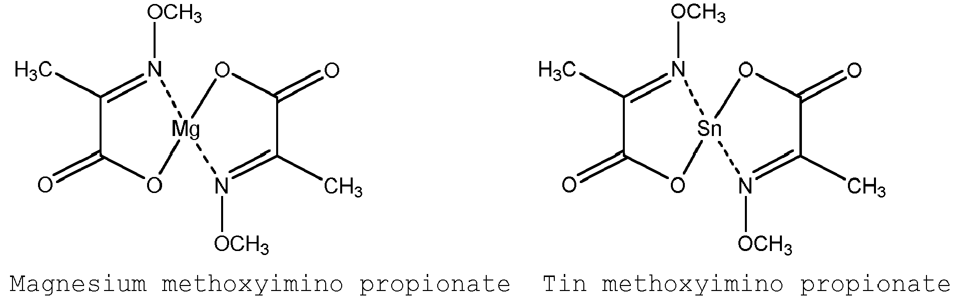

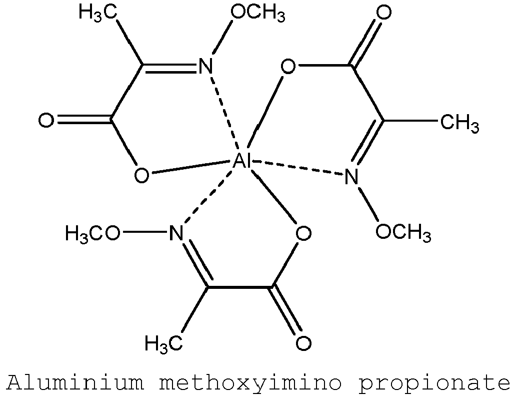

Although the above-mentioned representative examples show a central metal atom that is attached to the ketoacidoximate group, it is also possible to have the central atom attached to other groups as well such as oxide, hydroxide, or any group R₃ such as carboxylate (acetate, etc.), glycinate, xanthate, alkyl, aryl, etc. The central metal atom could be monovalent, divalent and above.

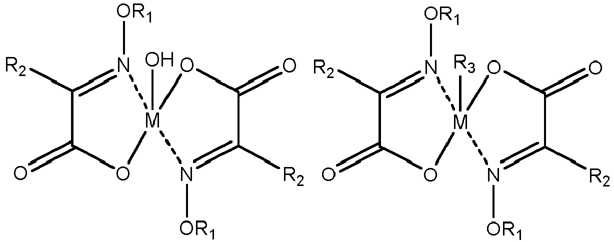

Adducts with Lewis bases bonded to central metal atoms are also possible.

The present invention also provides for a process for patterning a semiconductor surface by coating the surface with the patterning agent and the irradiating of the coated surface with a predefined photon irradiation pattern or electron beam pattern. In this process, appropriate amounts of patterning agents, here photoresists, were dissolved in a solvent, for example 2-methoxyethanol, to give concentrations between 0.0125 gm/ml to 0.1 gm/ml. For film thicknesses below 50 nm, concentrations in the range of 0.0125 gm/ml to 0.025 gm/ml are found to be suitable. These solved resists were spin-coated on pre-cleaned semiconductor substrates, for example silicon substrates, at an appropriate spin-speed, for example a spin-speed of 1800 rpm. They were then exposed to photon radiation, for example EUV radiation, through a mask at a photon source or to electrons, for example 100 kV electrons, inside an electron beam writer. The photon radiation can be generated for example in a synchrotron, for example at the Swiss Light Source (SLS) in Villigen PSI, Switzerland (visit for more details on the SLS at www.psi.ch).

For studying the sensitivity of resists to plot dose-to-gel curves, they were exposed at various doses using EUV or electrons. These resists were developed with various organic solvents such as methanol, ethanol, iso-propanol, 2-methoxyethanol, 1-methoxy-2-propanol, 1-butoxyethanol, 3-methoxy-1-butanol, 2-methoxyethyl acetate, and 1-methoxy-2-propyl acetate. They were rinsed using the same solvent in which they were developed. For dose-to-gel curves, 10 seconds of development, immediately followed by 5 second rinse, and then blow-drying using nitrogen. The resists showed a negative tone behavior after exposure.

For EUV patterning, the resists were exposed through a grating mask. On the other hand, predefined patterns were used for electron beam lithography.

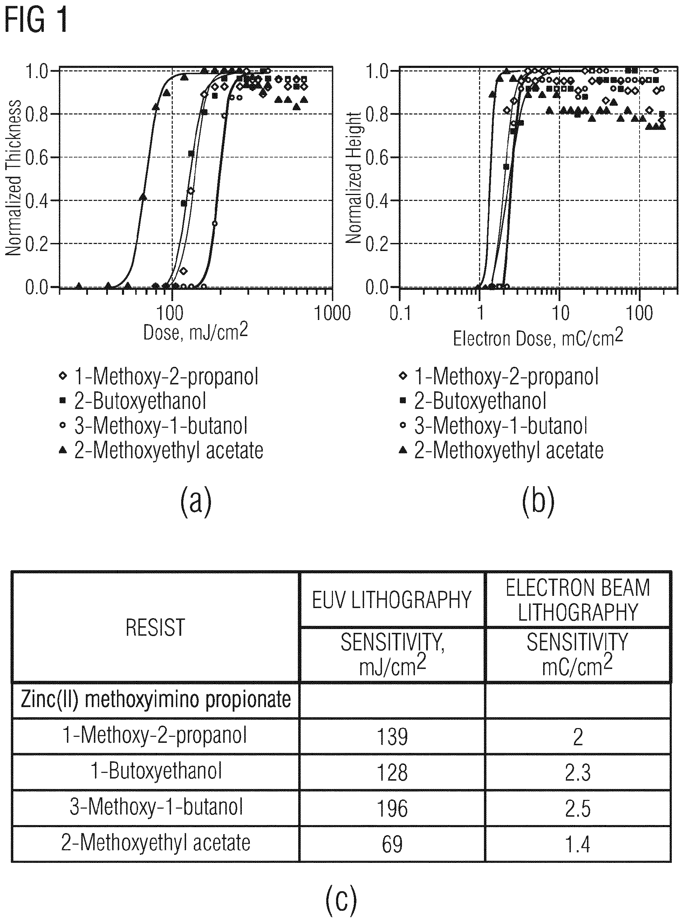

Figure 1 shows dose-to-gel curves of zinc(II) methoxyimino propionate resists exposed to (a) EUV and (b) electron beam. Figure 1(c) shows the sensitivity values of the resist obtained with various developers.

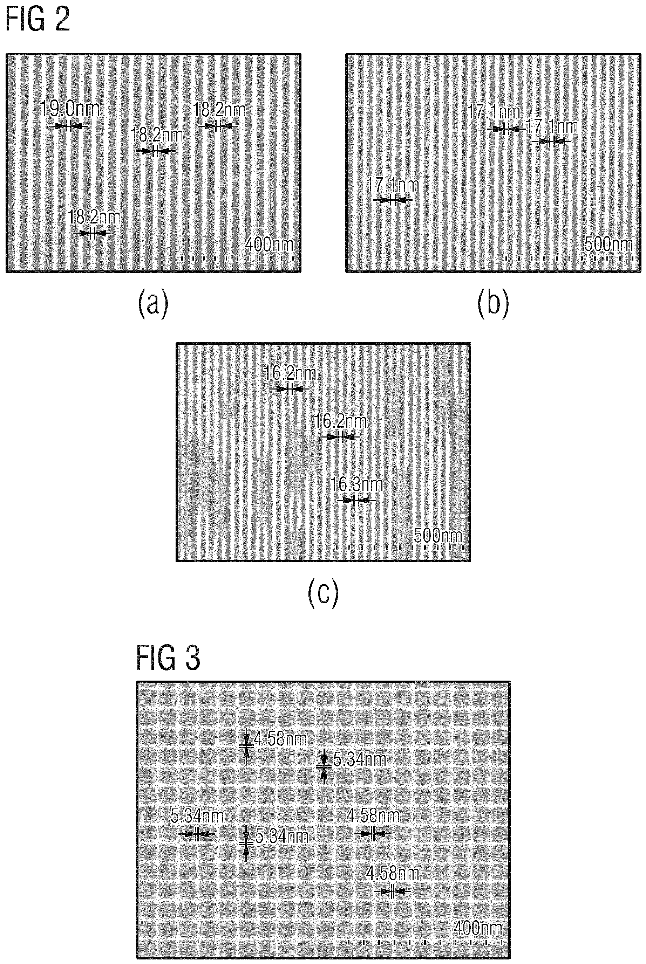

Figure 2 shows EUV lithography of (a) half pitch 22 nm (325 mJ/cm²), (b) half-pitch 18 nm (297 mJ/cm²), and (c) half pitch 16 nm (290 mJ/cm²) lines using zinc(II) methoxyimino propionate resist.

Figure 3 shows an electron beam lithography of 5 nm wide lines patterned using zinc(II) methoxyimino propionate resist.

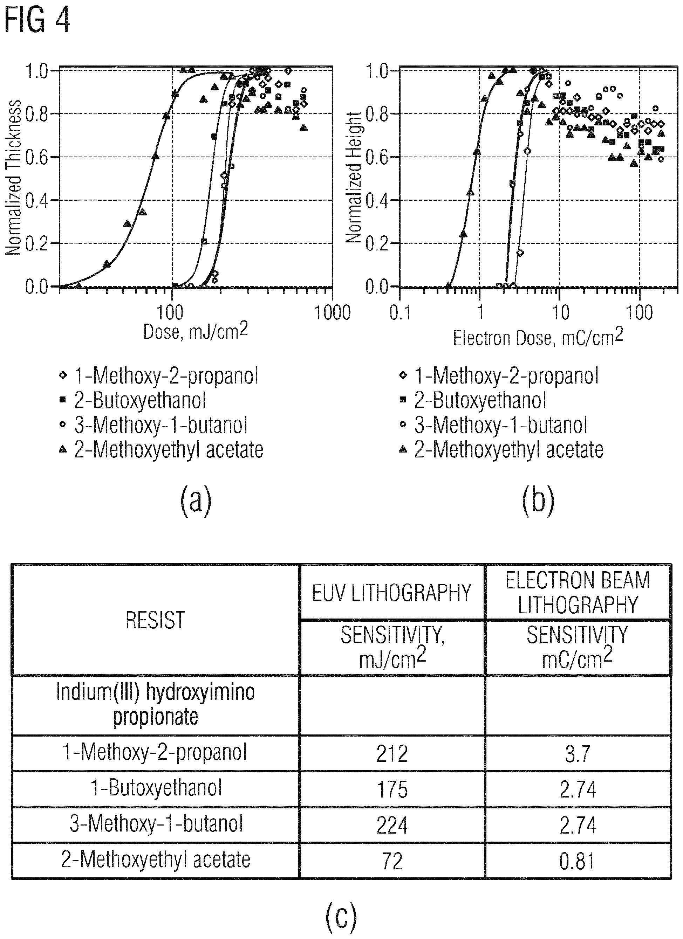

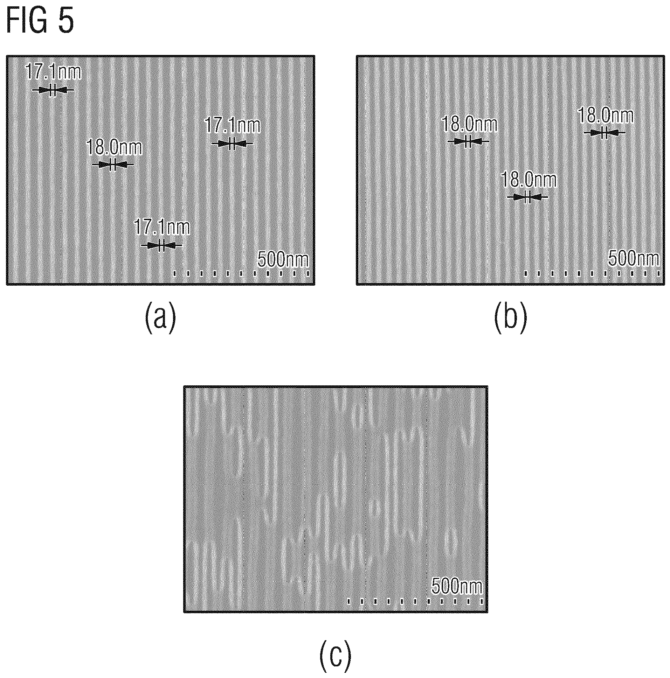

Figure 4 now shows the dose-to-gel curves of indium(III) hydroxyimino propionate resist exposed to (a) EUV and (b) electron beam. Figure 4(c) shows the sensitivity values of the resist obtained with various developers. Figure 5 shows the EUV lithography of (a) half pitch 22 nm (222 mJ/cm²), (b) half-pitch 18 nm (223 mJ/cm²), and (c) half pitch 16 nm (199 mJ/cm²) lines using indium(III) hydroxyimino propionate resist. Features here are slightly smaller than the designed half pitch due to underdosing.

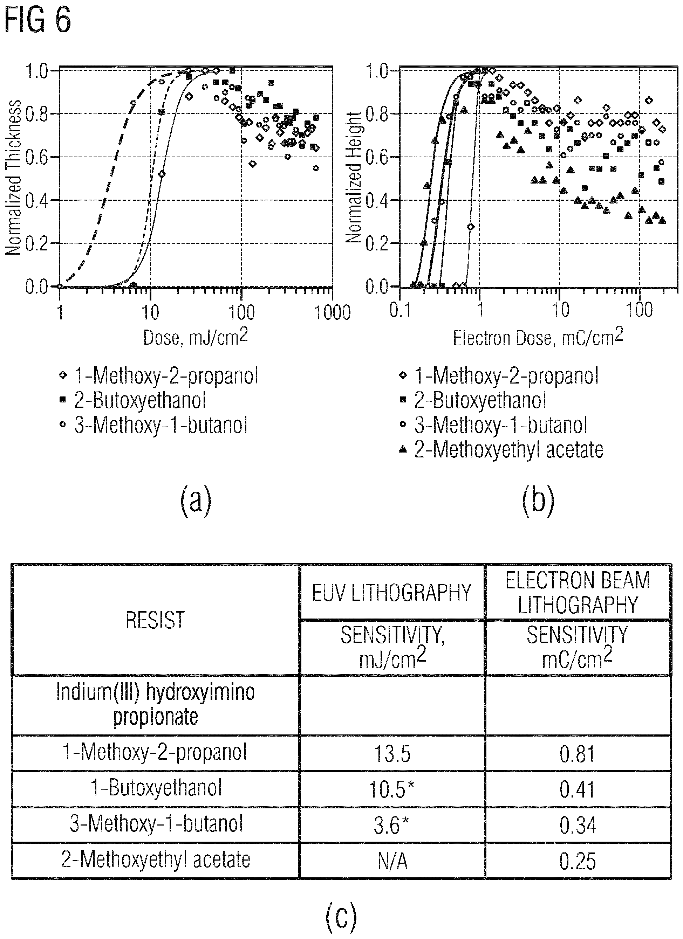

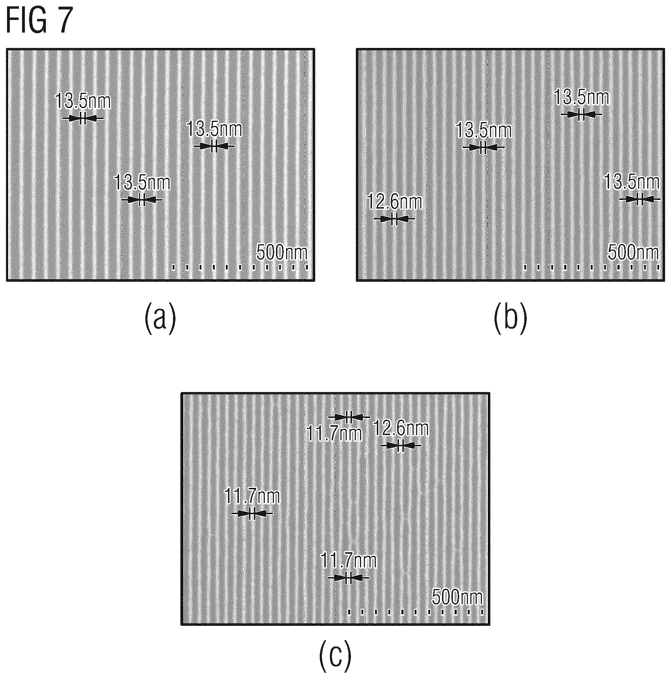

Figure 6 shows the dose-to-gel curves of indium(III) methoxyimino propionate resist exposed to (a) EUV and (b) electron beam. Figure 6(c) shows the sensitivity values of the resist obtained with various developers. '*' indicates data from poor development characteristics. 'N/A' indicates that data could not be acquired due to excessive scum on the surface. Figure 7 shows the EUV lithography of (a) half pitch 22 nm (193 mJ/cm²), (b) half-pitch 18 nm (194 mJ/cm²), and (c) half pitch 16 nm (173 mJ/cm²) lines using indium(III) methoxyimino propionate resist. Features here are slightly smaller than the designed half pitch due to underdosing.

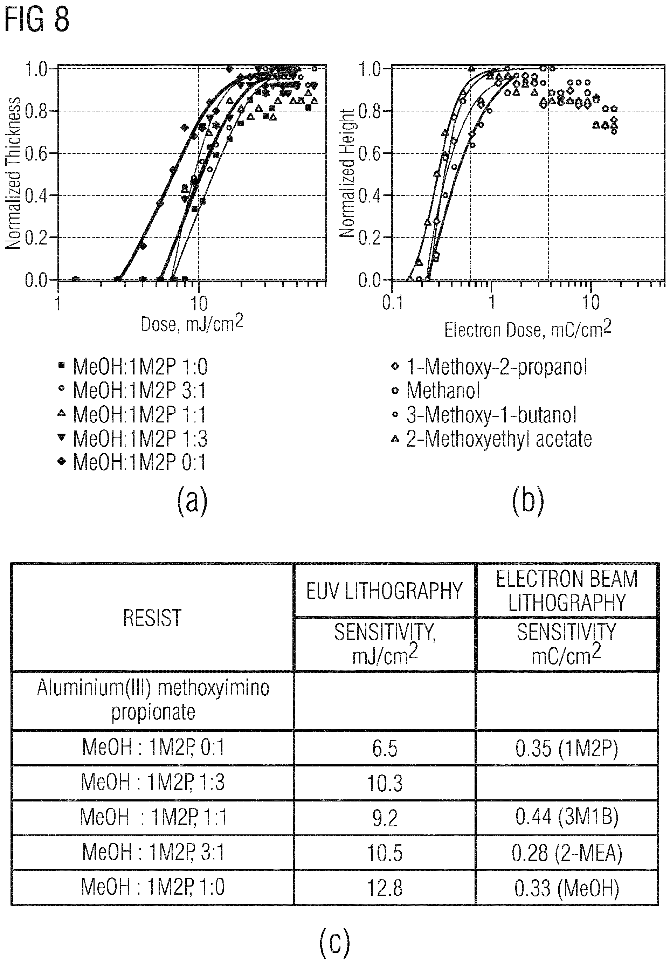

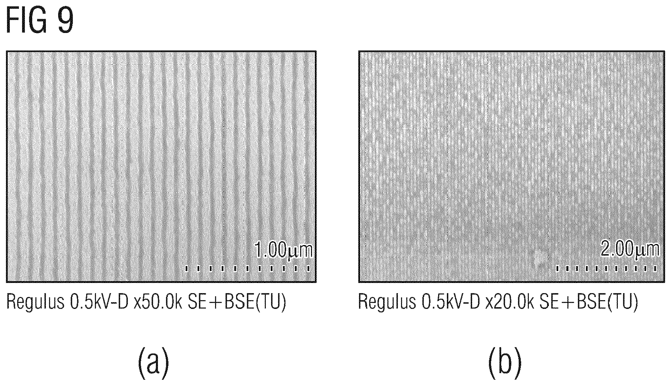

Figure 8 shows the dose-to-gel curves of aluminium(III) methoxyimino propionate resist exposed to (a) EUV and (b) electron beam. Figure 8(c) shows the sensitivity values of the resist obtained with various developers. MeOH = methanol; 1M2P = 1-methoxy-2-propanol; 3M1B = 3-methoxy-1-butanol; 2-MEA = 2-methoxyethyl acetate. Figure 9 shows the EUV lithography of (a) half pitch 50 nm (64 mJ/cm²), and (b) half-pitch 35 nm (51 mJ/cm²) using aluminium(III) methoxyimino propionate resist. The resist shows excessive scum between the lines at lower pitches.

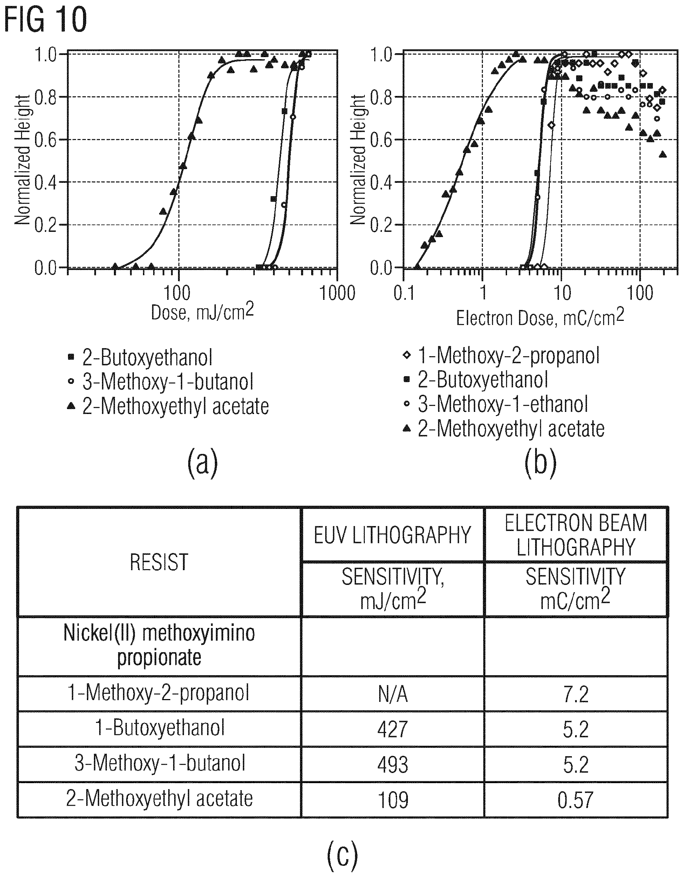

Figure 10 shows the dose-to-gel curves of nickel(II) methoxyimino propionate resist exposed to (a) EUV and (b) electron beam. Figure 10(c) shows the sensitivity values of the resist obtained with various developers. 'N/A' indicates that data could not be acquired due to no feature seen on the surface.

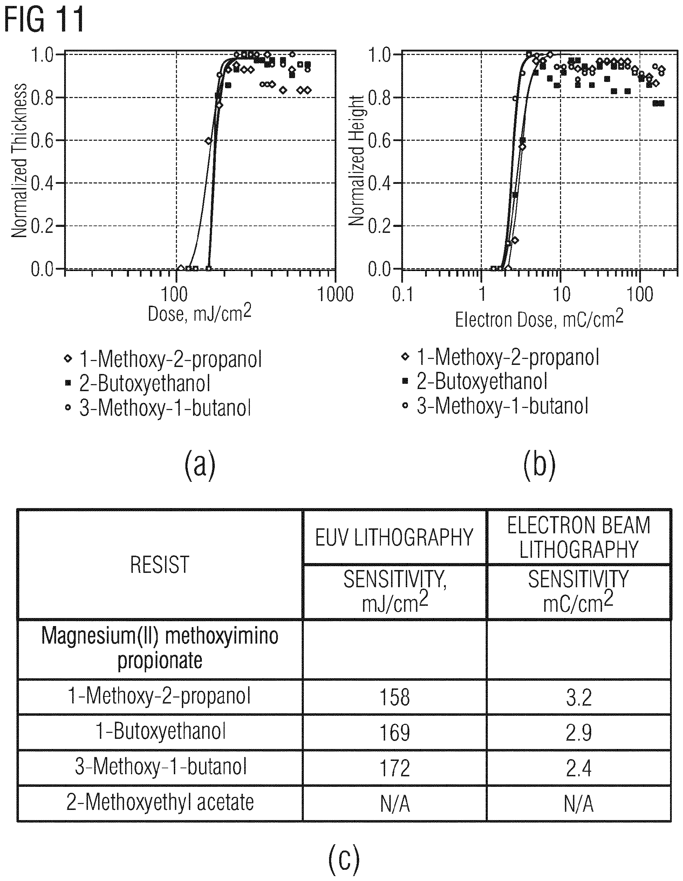

Figure 11 shows the dose-to-gel curves of magnesium(II) methoxyimino propionate resist exposed to (a) EUV and (b) electron beam. Figure 11(c) shows the sensitivity values of the resist obtained with various developers. 'N/A' indicates that data could not be acquired due to no development at all.

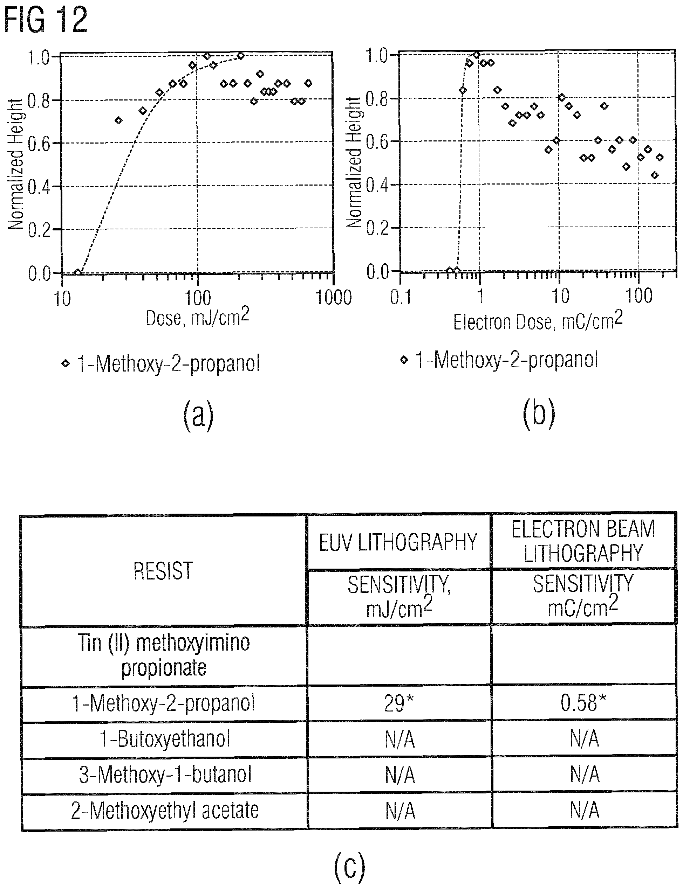

Figure 12 shows the dose-to-gel curves of tin(II) methoxyimino propionate resist exposed to (a) EUV and (b) electron beam. Figure 12(c) shows the sensitivity values of the resist obtained with various developers. '*' indicates data from poor development characteristics. 'N/A' indicates that data could not be acquired due to excessive scum on the surface.

Major advantages of the metal/metal compound Ketoacidoximate resist system include
▪ Features a novel molecular resist system with low molecular mass (<500 daltons), which become critical for sub-10 nm patterns.
▪ Tailorable organic environment (in at least 15 possible ways) around the central metal(loid) atom yet keeping the mass close to 500 daltons
▪ Compatible with both EUV and electron beam lithographies
▪ Incorporates a universal scheme for patterning metal / metalloid-containing functional resists
▪ Possibility of incorporating metal atoms, such as aluminium that pose no risk of contamination in the semiconductor manufacturing fabs.
▪ Possibility of doping with heavy elements, such as cesium, for further improvement of the EUV or e-beam absorption to increase the sensitivity.
▪ High sensitivities to EUV and electron beam exposure
▪ Resists are sub-5 nm lithography capable and possibly angstrom-scale lithography as well using an electron beam

Figure 13 provides theoretically calculated EUV absorption cross-section of various elements. The data here provide guidelines for the choice of elements in EUV resists. Typically, elements with higher EUV absorption cross-section are preferred. In detail, Figure 13 shows the atomic absorption cross section σₐ at EUV (λ = 13.5 nm) of elements with atomic number Z from 1 to 86.

## Claims

1. The use of a metal and/or metalloid-comprising ketoacidoximate and/or a metal-compound-comprising ketoacidoximate as a patterning agent in photolithography and electron beam lithography with applications in the field of semiconductor chip production, and direct patterning of functional materials for mask production, sensors, photonics or catalysis.

2. The use according to claim 1, wherein a divalent metal or metalloid or metal-compound comprising ketoacidoximate has one of the following structural forms: 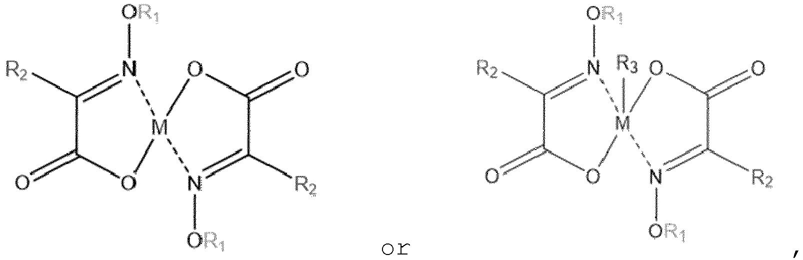 wherein:
R₁ and R₂ stand for hydrogen (H), organic groups, such as aliphatic C₁ to C₁₀, aromatic, cyclic, polymerizable, such as acrylate, methacrylate, vinyl, etc., or a combination of these; and
M stands for a central metal or metalloid atom, which can be monovalent, divalent, trivalent, tetravalent, pentavalent or higher, that is attached to the ketoacidoximate group in monodentate, bidentate, or tridentate fashion, and/or M stands for a central metal atom being attached to other groups such as oxide, hydroxide, etc., or a central metal atom being attached to a further group R₃ which is a carboxylate such as acetate, etc., a glycinate, a xanthate, an alkyl, an aryl, or the like.

3. The use according to claim 1 or 2, wherein the metal is selected from a group comprising zinc, indium, aluminium, nickel, magnesium and tin.
